# EUROPEAN PATENT APPLICATION

(11) **EP 3 734 941 A1**
(43) Date of publication of application: **04.11.2020**
(21) Application number: 19190537.1
(22) Date of filing: 07.08.2019
(51) Int. Cl.: H04M 1/02, G06F 1/16, H04M 1/21, H04M 1/22, H04M 1/18, H04M 1/04

(54) **SMART MIRROR DEVICE**

(30) Priority: 02.05.2019 TW 108205402 U
(71) Applicant: CAL-COMP BIG DATA, INC, Shenkeng, New Taipei City 222 (TW)
(72) Inventor: LIU, Chia-Chen, 222 New Taipei City (TW); HSU, Chun-An, 222 NEW TAIPEI CITY (TW)
(74) Representative: 2K Patentanwälte Blasberg Kewitz & Reichel

(57) **Abstract**

A smart mirror device (10) includes a display device (1) and a mirror cover (2). The display device (1) has a screen (11); the mirror cover (2) is slidably mounted onto the display device (1) and slides between a covering position covering the screen (11) and an exposed position exposed form the screen (11); and a mirror (21) is installed outside the mirror cover (2). When the mirror cover (2) is situated at the exposed position, the mirror (21) is disposed on a side of the screen (11). Therefore, users may detect their skin, receive skincare and makeup tips, watch movies, or use applications (APP) while looking at the mirror (21). The smart mirror device (10) has the advantage of showing clear images in the mirror (21) and the screen (11).

## Description

### BACKGROUND OF THE INVENTION

### 1. Technical Field

The technical field relates to mirror devices, and more particularly to a smart mirror device.

### 2. Description of Related Art

At present, there is a smart mirror combining a mirror with a screen is commercially available, and the smart mirror is generally equipped with devices such as a lens, a speaker, a Wi-Fi and/or Bluetooth networking device, so that users can detect skin conditions and receive skincare, maintenance and makeup tips. The users may also watch movies and use applications (APP) through the Internet while looking at the mirror, so that the users can utilize the mirror fully and effectively.

However, the conventional smart mirror has the following drawbacks. Since the screen uses the principle of refraction to visualize an image, and the mirror uses the principle of reflection to show the image and a bronze mirror or a grey mirror to transmit light, reflect light and produce inverted images. The smart mirror is generally made of the bronze or grey mirror in order to meet the screen and mirror requirements, but the smart mirror used as a screen will not be as clear as an LCD screen, and the smart mirror used as a mirror is not as clear as a general mirror.

In view of the aforementioned drawbacks, the discloser of this disclosure based on years of experience in the related industry to conduct extensive research and experiment, and finally provided a feasible solution to overcome the drawbacks of the prior art.

### SUMMARY OF THE INVENTION

The disclosure is directed to a smart mirror device with a mirror installed adjacent to a side of a screen, so that users can detect their skin, receive skincare, maintenance and makeup tips, watch movies, or use applications (APP) while looking at the mirror. The smart mirror device of this disclosure has the advantages of showing images similar to those displayed on a mirror and a screen.

In an embodiment of this disclosure, a smart mirror device comprises: a display device, having a screen; and a mirror cover, slidably mounted onto the display device and sliding between a covering position covering the screen and an exposed position exposed on the screen, and a mirror disposed at the exterior of the mirror cover; wherein when the mirror cover is situated at the exposed position, the mirror is disposed parallel to a side of the screen.

Wherein, the mirror and the screen are two independent and separate structures, and the reflection of the mirror and the refraction of the screen will not affect each other, so that the smart mirror device has the features of showing images as clear as those displayed on a mirror and a screen.

Wherein, the screen has a message display area and a sensor, and the mirror has a hollow area, and when the mirror cover is situated at the covering position, the position of the hollow area is overlapped with the message display area and the position of the sensor, and after the sensor receives a user's operation through the hollow area, the sensor can display a prompt message in the message display area, and the user can view the prompt message from the hollow area without sliding the mirror cover away from the screen,, so as to improve the convenience of using the smart mirror device.

### BRIEF DESCRIPTION OF THE DRAWINGS

FIG. 1 is a perspective view of a smart mirror device in accordance with a first embodiment of this disclosure;
FIG. 2 is an exploded view of a smart mirror device in accordance with the first embodiment of this disclosure;
FIG. 3 is another exploded view of a smart mirror device in accordance with the first embodiment of this disclosure;
FIG. 4 is a partial cross-sectional view of a smart mirror device in accordance with the first embodiment of this disclosure;
FIG. 5 is a further exploded view of a smart mirror device in accordance with a first embodiment of this disclosure;
FIG. 6 is another perspective view of a smart mirror device in accordance with the first embodiment of this disclosure;
FIG. 7 is a further perspective view of a smart mirror device in accordance with the first embodiment of this disclosure;
FIG. 8 is a schematic view showing a using status of a smart mirror device in accordance with the first embodiment of this disclosure;
FIG. 9 is a schematic view showing another using status of a smart mirror device in accordance with the first embodiment of this disclosure;
FIG. 10 is a schematic view showing a using status of a smart mirror device in accordance with a second embodiment of this disclosure;
FIG. 11 is a perspective view of a smart mirror device in accordance with a third embodiment of this disclosure;
FIG. 12 is a perspective view of a smart mirror device in accordance with a fourth embodiment of this disclosure;
FIG. 13 is a perspective view of a smart mirror device in accordance with a fifth embodiment of this disclosure; and
FIG. 14 is a perspective view of a smart mirror device in accordance with a sixth embodiment of this disclosure.

### DESCRIPTION OF THE PREFERRED EMBODIMENTS

The technical contents of this disclosure will become apparent with the detailed description of preferred embodiments accompanied with the illustration of related drawings as follows. It is intended that the embodiments and drawings disclosed herein are to be considered illustrative rather than restrictive.

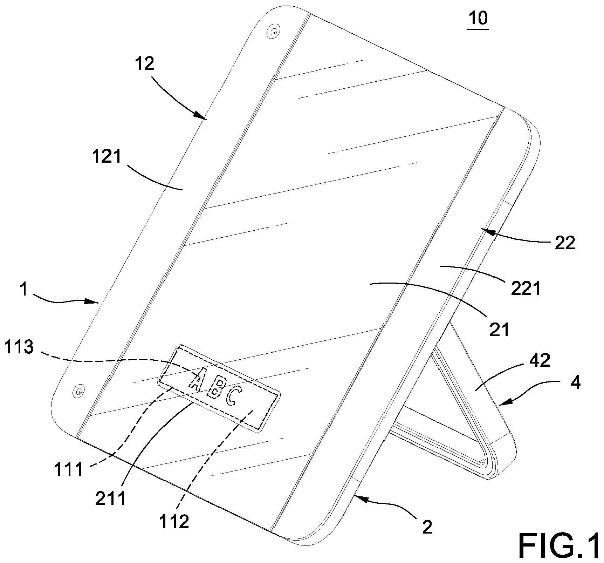

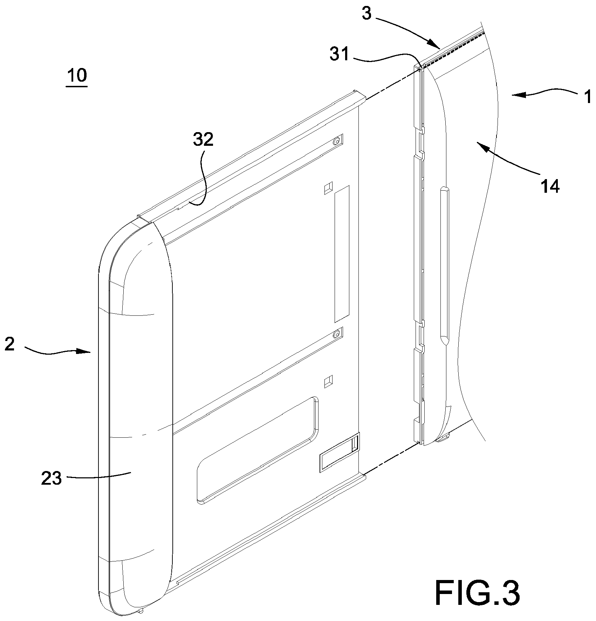

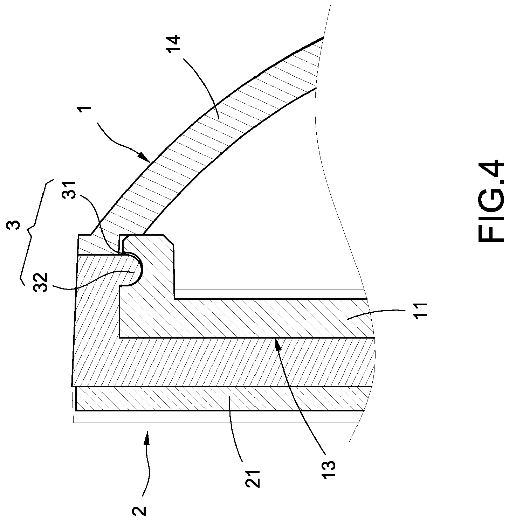

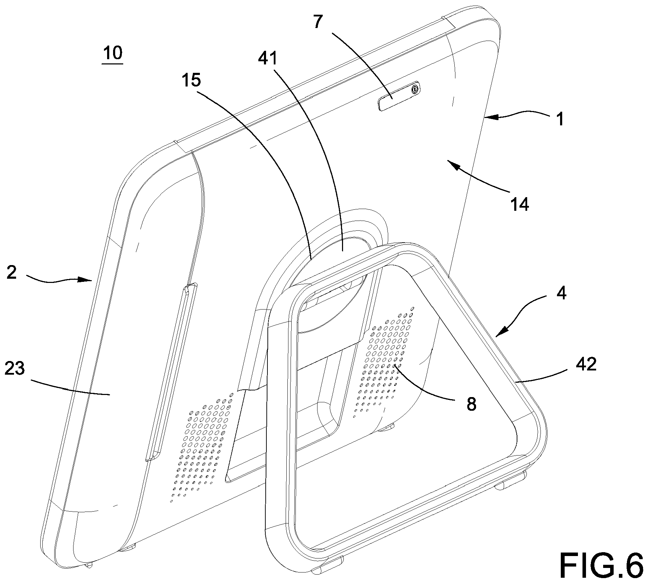

With reference to FIGS. 1 to 9 for the smart mirror device in accordance with the first embodiment of this disclosure, the smart mirror device 10 comprises a display device 1 and a mirror cover 2.

In FIGS. 1 to 9, the display device 1 has a screen 11, and the screen 11 has a message display area 111, and the message display area 111 has a sensor 112. Wherein, the display device 1 has a front 13 and a back 14, and the screen 11 is installed at the front 13. Wherein, the back 14 has a connector socket 141 and a restart jack 142 for USB and DC IN connection, and the connector socket 141 is provided for engaging with a connector, and the restart jack 142 is provided for turning off and then resetting the display device 1 when there is an insertion at the restart jack 142.

In FIGS. 1 to 9, the mirror cover 2 is slidably mounted onto the display device 1 and capable of sliding between a covering position covering the screen 11 and an exposed position exposed from the screen 11, and a mirror 21 is installed outside the mirror cover 2.

In addition, the mirror 21 has a hollow area 211, and when the mirror cover 2 is situated at the exposed position, the mirror 21 is disposed parallelly on a side of the screen 11, and when the mirror cover 2 is situated at the covering position, the position of the hollow area 211 is overlapped with the message display area 111 and the position of the sensor 112.

In addition, the display device 1 further has a first light emitting structure 12, and the mirror cover 2 further has a second light emitting structure 22, and both of the first light emitting module 12 and the second light emitting module 22 are disposed on both opposite outer sides of the screen 11 and the mirror 21.

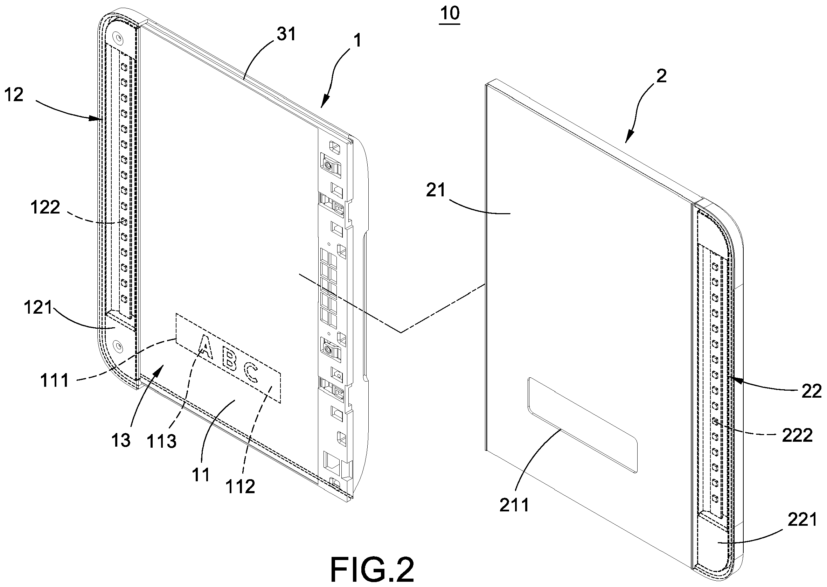

In FIG. 2, the first light emitting structure 12 comprises a first matte cover 121 and a first light emitting element 122 contained in the first matte cover 121, and the first matte cover 121 is installed on a side of the screen 11 and between two rail structures 3, and the second light emitting structure 22 comprises a second matte cover 221 and a second light emitting element 22 contained in the second matte cover 221, and the second matte cover 221 is installed between a side of the mirror 21 and the two rail structures 3, and the first matte cover 121 and the second matte cover 221 are provided for diffusing and softening light, so that the first light emitting module 12 and the second light emitting module 22 can provide an excellent fill-light effect.

In addition, when the sensor 112 receives a user's operation, a prompt message 113 is displayed on the message display area 111, or the first light emitting module 12 and the second light emitting module 22 are lit.

Further, the sensor 112 of this disclosure has three ways of receiving the user's operation as follows: 1. When the sensor 112 is a resistive touch sensor, and the hollow area 211 is a light transmission opening, a user may press the sensor 112 directly, or press the sensor 112 through the hollow area 211, and the sensor 112 is pressed by an external force to generate an output signal. 2. When the sensor 112 is a capacitive touch sensor, and the hollow area 211 is a light transmission opening, the user may touch the sensor 112 directly or touch the sensor 112 through the hollow area 211, and the sensor 112 will generate an output signal when a change of capacitance is detected. 3. When the sensor 112 is a wave-motion touch sensor and the hollow area 211 is a light transmission opening or a light transmission area composed of unpainted mirrors, the user may touch the sensor 112 directly or approaches to the sensor through the hollow area 211, and the sensor 112 will generate an output signal after detecting that an infrared light is blocked. After receiving the output signal, a controller (not shown in the figure) installed in the display device 1 will control the message display area 111 to display the prompt message 113, or light up the first light emitting module 12 and the second light emitting module 22.

Wherein, when the position of the hollow area 211 is overlapped with the position of the message display area 111, the user can view the prompt message 113 through the hollow area 211, and the form of the prompt message 113 is not limited to that of this embodiment only, but it can be any text or pattern.

In FIGS. 2 to 4, both of the display device 1 and the mirror cover 2 are disposed at the two rail structures 3 on both upper and lower sides of the screen 11 respectively, and the mirror cover 2 slides along the two rail structures 3, and each rail structure 3 comprises a chute 31 formed on the display device 1 and a slider 32 extending from the mirror cover 2, and each slider 32 slides at each respective chute 31, so that the mirror cover 2 can slide to move closer to or away from the first light emitting structure 12.

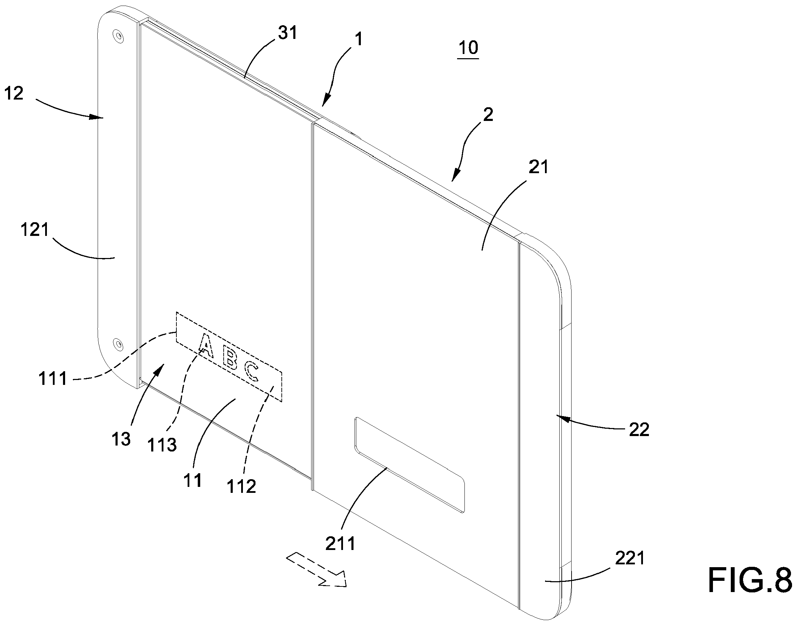

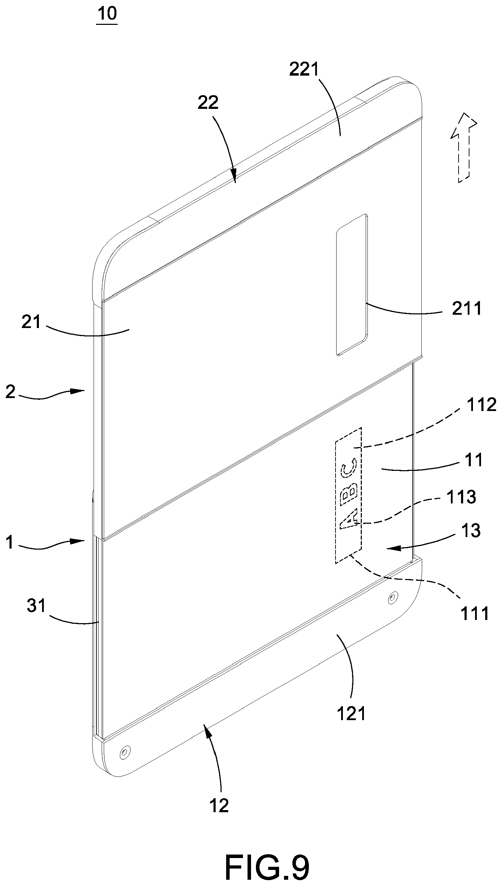

In FIG. 8, when the two rail structures 3 are disposed parallelly on the ground, the mirror cover 2 slides along the two rail structures 3 and sideway with respect to the display device 1. In FIG. 9, when the two rail structures 3 are disposed vertically on the ground, the mirror cover 2 slides along the two rail structures 3 and vertically up and down with respect to the display device 1. Therefore, the mirror cover 2 of the smart mirror device 10 can selectively slide sideway or vertically up and down with respect to the display device 1 by the set position of the two rail structures 3.

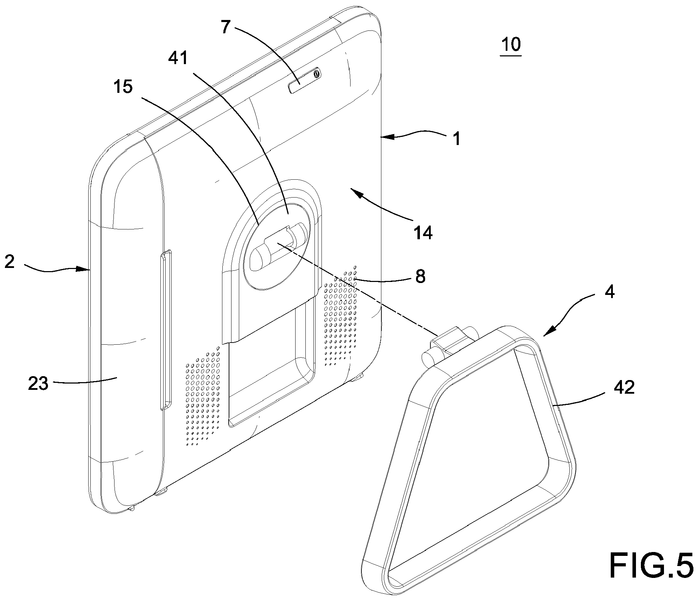

In FIGS. 5 to 7, the smart mirror device 10 of this disclosure further comprises a rotating support 4, and the back 14 has a snap slot 15, and the rotating support 4 has a rotary head 41 and a support 42 pivotally coupled to the rotary head 41, wherein the rotary head 41can be rotatably embedded into snap slot 15 with an angle of 360 degrees, and the smart mirror device 10 stands on a plane such as a desktop through the rotating support 4, so that the rotating support 4 can support the smart mirror device 10 to stand on a plane such as a desktop when the smart mirror device 10 is set at any angle. Wherein, the back 14 of the display device 1 further has a power button 7 and a speaker hole 8, but this disclosure is not limited to such arrangements.

With reference to FIGS. 1, 2, 8, and 9 for a using status of the smart mirror device 10 of this disclosure, when a mirror cover 2 is situated at the exposed position, the mirror 21 is disposed parallelly on a side of the screen 11 to allow users to look at the mirror 21 while detecting their skin, receiving skincare and maintenance, watching movies or using applications (APP).

Compared with the conventional smart mirror with the problem of unclear screen and mirror, the mirror 21 and the screen 11 of this disclosure are two separate structures, so that the reflection of the mirror 21 and the refraction of the screen 11 will not affect each other, and the mirror 21 and the screen 11 of the smart mirror device 10 of this disclosure have the feature of showing clear images.

In addition, when the mirror cover 2 is situated at the covering position, the mirror cover 2 covers the screen 11, and the position of the hollow area 211 is overlapped with the message display area 111 and the position of the sensor 112. After receiving a user's operation through the hollow area 211, the sensor 112 displays the prompt message 113 in the message display area 111 without sliding the mirror cover 2 away from the screen 11, and allows the user to view the prompt message 113 from the hollow area 211, so as to improve the convenience of use of the smart mirror device 10.

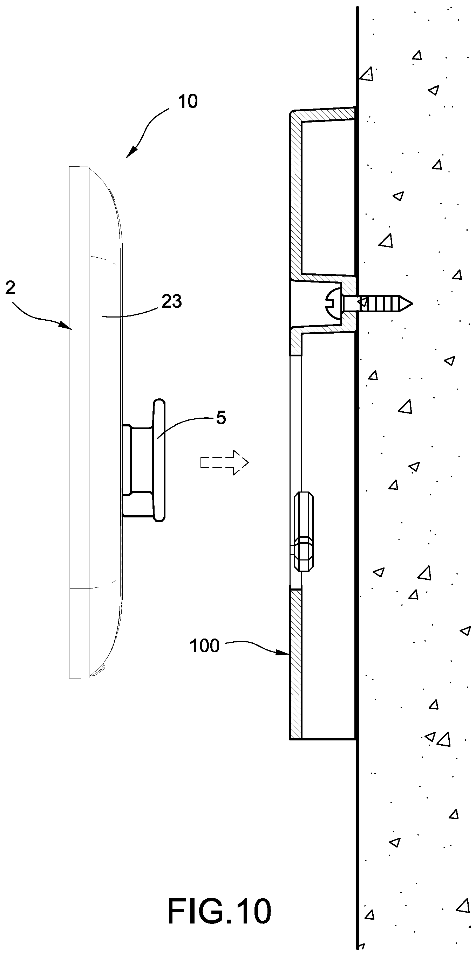

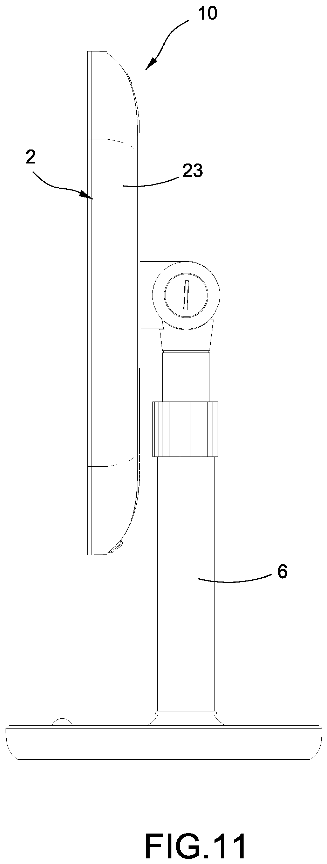

With reference to FIGS. 10 and 11 for the smart mirror devices 10 in accordance with the second and third embodiments of this disclosure respectively, the second and third embodiments are substantially the same as the first embodiment except that the back 14 of the display device 1 can be used for installing a hook 5 or a support base 6.

In FIG. 10, the back 14 of the display device 1 is installed with the hook 5, so that the smart mirror device 10 can be hanged onto the hanging seat 100 on a wall by using the hook 5. In FIG. 11, the back 14 of the display device 1 is installed with the support base 6, so that the smart mirror device 10 can be placed on a plane such as a desktop by using the support base 6.

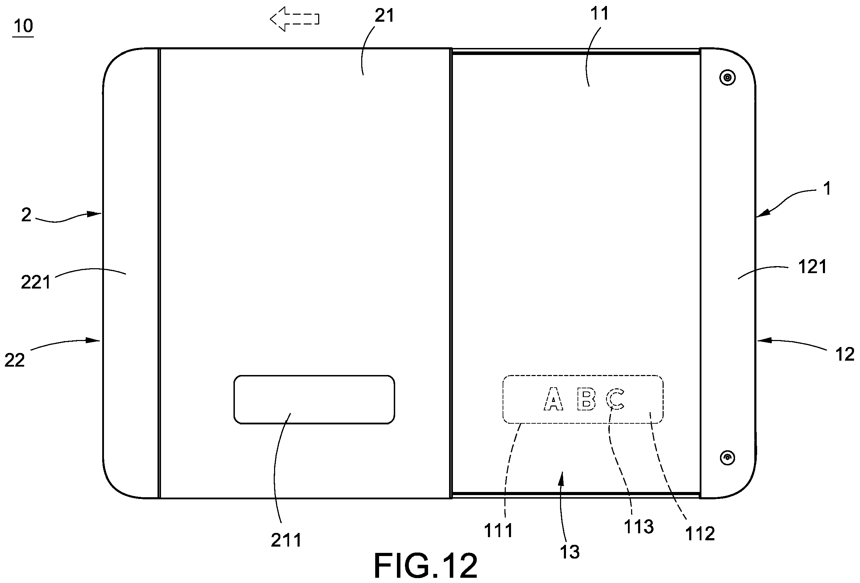

With reference to FIG. 12 for the smart mirror device 10 in accordance with the fourth embodiment of this disclosure, the fourth embodiment is substantially the same as the first embodiment except that the display device 1 and the mirror cover 2 of the fourth embodiment are disposed at different position positions.

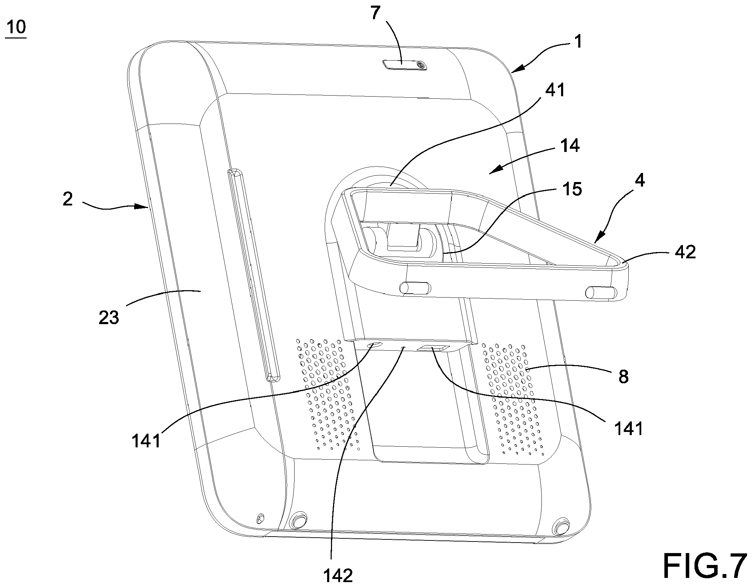

In FIG. 7, when the mirror cover 2 is disposed at the exposed position, the mirror cover 2 is installed on the right side of the display device 1, so that the mirror 21 is disposed on the right side of the screen 11, but this disclosure is not limited to such arrangement only. In FIG. 12, when the mirror cover 2 is situated at the exposed position, the mirror cover 2 may be installed on the left side of the display device 1, so that the mirror 21 is disposed on the left side of the screen 11.

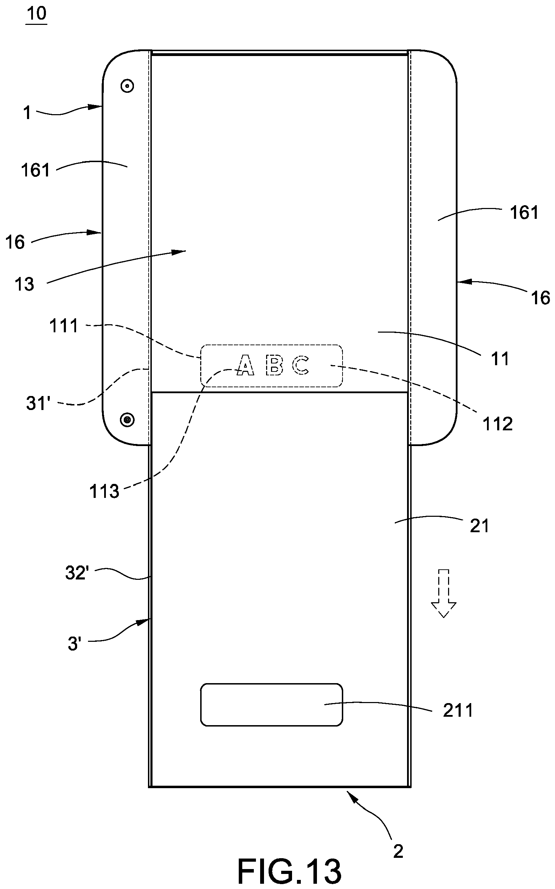

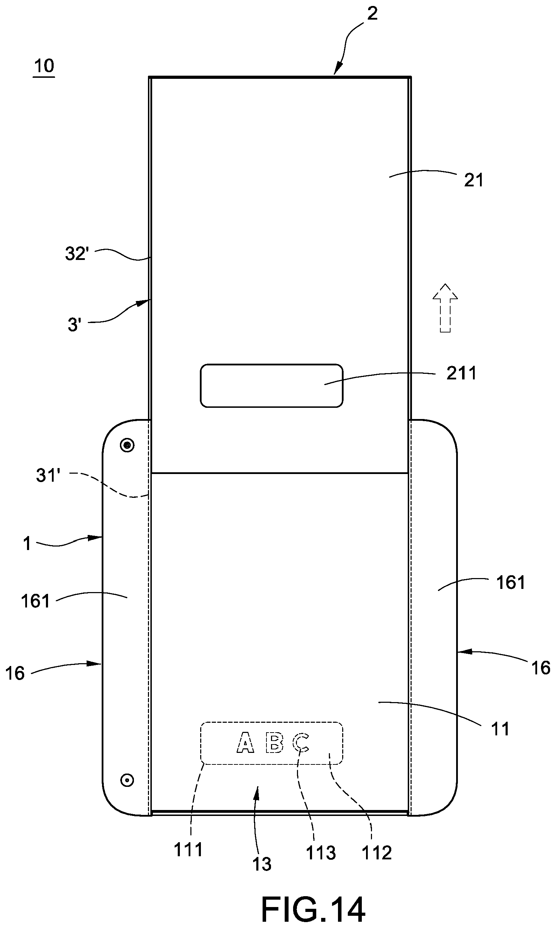

With reference to FIGS. 13 and 14 for the smart mirror devices 10 in accordance with the fifth and sixth embodiments of this disclosure respectively, the fifth and sixth embodiments are substantially the same as the first embodiment except that the display device 1 and the mirror cover 2 are disposed at different positions.

In FIG. 13, when the mirror cover 2 is situated at the exposed position, the mirror cover 2 may be installed at the bottom of the display device 1, so that the mirror 21 is disposed at the lower side of the screen 11. In FIG. 14, when the mirror cover 2 is situated at the exposed position, the mirror cover 2 may be installed at the top of the display device 1, so that the mirror 21 is disposed at the upper side of the screen 11.

In addition, the display device 1 further has two lighting assemblies 16 installed on both opposite outer sides of the screen 11 respectively. When receiving a user's operation, the sensor 112 will generate an output signal, and controller (not shown in the figure) installed in a display device 1 will light up the two lighting assemblies 16 when receiving the output signal.

Wherein, both of the display device 1 and the mirror cover 2 are disposed at two rail structures 3' on both left and right sides of the screen 11 respectively, and the mirror cover 2 slides along the two rail structures 3'.

Specifically, each lighting assembly 16 comprises a matte cover 161 and a light emitting element contained in the matte cover 161, and the two rail structures 3' are installed between the outer side of the screen 11 and the inner sides of the two matte covers 161, and each rail structure 3' comprises a chute 31' formed on the display device 1 and a slider 32' extending from the mirror cover 2, and each slider 32' slides in each respective chute 31', so that the mirror cover 2 can slide up and down with respect to the two lighting assemblies 16.

## Claims

1. A smart mirror device, comprising:
a display device (1), having a screen (11); and
a mirror cover (2), slidably mounted onto the display device (1) and sliding between a covering position of the screen (11) and an exposed position of the screen (11), and having a mirror (21) installed outside the mirror cover (2);
wherein, when the mirror cover (2) is situated at the exposed position, the mirror (21) is disposed parallelly on a side of the screen (11).

2. The smart mirror device according to claim 1, wherein the screen (11) has a message display area (111), and the mirror (21) has a hollow area (211), and when the mirror cover (2) is situated at the covering position, the position of the hollow area (211) is overlapped with the position of the message display area (111).

3. The smart mirror device according to claim 2, wherein the message display area (111) has a sensor (112), and when the mirror cover (2) is situated at the covering position, the position of the hollow area (211) is overlapped with the position of the sensor (112).

4. The smart mirror device according to claim 3, wherein the sensor (112) displays a prompt message (113) in the message display area (111) when receiving a user's operation.

5. The smart mirror device according to claim 3, wherein the display device (1) further has a first light emitting structure (12), and the mirror cover (2) further has a second light emitting structure (22), and both of the first light emitting structure (12) and the second light emitting structure (22) are installed on two opposite outer sides of the screen (11) and the mirror (21) respectively.

6. The smart mirror device according to claim 5, wherein the sensor (112) lights up the first light emitting structure (12) and the second light emitting structure (22) when receiving a user's operation,

7. The smart mirror device according to claim 5, wherein both of the display device (1) and the mirror cover (2) are disposed at the two rail structures (3) on the upper and lower sides of the screen (11) respectively, and the mirror cover (2) slides along the two rail structures (3).

8. The smart mirror device according to claim 7, wherein the first light emitting structure (12) comprises a first matte cover (121) and a first light emitting element (122) contained in the first matte cover (121), and the first matte cover (121) is installed between a side of the screen (11) and the two rail structures (3), and the second light emitting structure (22) comprises a second matte cover (221) and a second light emitting element (22) contained in the second matte cover (221), and the second matte cover (221) is installed between a side of the mirror (21) and the two rail structures (3).

9. The smart mirror device according to claim 7, wherein each rail structure (3) comprises a chute (31) formed on the display device (1) and a slider (32) extending from the mirror cover (2), and each slider (32) slides in each respective chute (31).

10. The smart mirror device according to claim 1, wherein the display device (1) has a front (13) and a back (14), and the screen (11) is installed at the front (13), and a hook (5) or a support base (6) is installed at the back (14).

11. The smart mirror device according to claim 1, further comprising a rotating support (4), a rotary head (41) of the rotating support (4), and a support (42) pivotally coupled to the rotary head (41), and the display device (1) having a front (13) and a back (14), and the screen (11) being installed at the front (13), and the back (14) having a snap slot (15), and the rotary head (41) being rotatably embedded into the snap slot (15) with 360 degrees.

12. The smart mirror device according to claim 3, wherein the display device (1) has two lighting assemblies (16) installed two opposite outer sides of the screen (11) respectively, and the sensor (112) lights up the two lighting assemblies (16) when receiving a user's operation.

13. The smart mirror device according to claim 12, wherein both of the display device (1) and the mirror cover (2) are disposed on two rail structures (3') on both left and right sides of the screen (11) respectively, and the mirror cover (2) slides along the two rail structures (3').

14. The smart mirror device according to claim 13, wherein each lighting assembly (16) comprises a matte cover (161) and a light emitting element contained in the matte cover (161), and the two rail structures (3') are installed between the outer side of the screen (11) and the inner side of the two matte covers (161), and each rail structure (3') comprises a chute (31') formed on the display device (1) and a slider (32') extending from the mirror cover (2), and each slider (32') slides in each respective chute (31').

## Amended claims

### Amended claims in accordance with Rule 137(2) EPC.

1. A smart mirror device, comprising:
a display device (1), having a screen (11); and
a mirror cover (2), slidably mounted onto the display device (1) and sliding between a covering position of the screen (11) and an exposed position of the screen (11), and having a mirror (21) installed outside the mirror cover (2);
wherein, when the mirror cover (2) is situated at the exposed position, the mirror (21) is disposed on a side of the screen (11),
**characterized in that** the screen (11) has a message display area (111), and the mirror (21) has a hollow area (211), and when the mirror cover (2) is situated at the covering position, the position of the hollow area (211) is overlapped with the position of the message display area (111).

2. The smart mirror device according to claim 1, wherein the message display area (111) has a sensor (112), and when the mirror cover (2) is situated at the covering position, the position of the hollow area (211) is overlapped with the position of the sensor (112).

3. The smart mirror device according to claim 2, wherein the sensor (112) is a resistive touch sensor, a capacitive touch sensor or a wave-motion touch sensor respectively for detecting an external force, a change of capacitance or an infrared light and to correspondingly generate an output signal,
wherein a controller in the display device displays a prompt message (113) in the message display area (111) when when the controller receives the output signal.

4. The smart mirror device according to claim 2, wherein the display device (1) further has a first light emitting structure (12), and the mirror cover (2) further has a second light emitting structure (22), and both of the first light emitting structure (12) and the second light emitting structure (22) are installed on two opposite outer sides of the screen (11) and the mirror (21) respectively.

5. The smart mirror device according to claim 4, wherein the sensor (112) the sensor (112) is a resistive touch sensor, a capacitive touch sensor or a wave-motion touch sensor respectively for detecting an external force, a change of capacitance or an infrared light and to correspondingly generate an output signal, wherein a controller in the display device lights up the first light emitting structure (12) and the second light emitting structure (22) when when the controller receives the output signal.

6. The smart mirror device according to claim 4, wherein both of the display device (1) and the mirror cover (2) are disposed at the two rail structures (3) on the upper and lower sides of the screen (11) respectively, and the mirror cover (2) slides along the two rail structures (3).

7. The smart mirror device according to claim 5, wherein the first light emitting structure (12) comprises a first matte cover (121) and a first light emitting element (122) contained in the first matte cover (121), and the first matte cover (121) is installed between a side of the screen (11) and the two rail structures (3), and the second light emitting structure (22) comprises a second matte cover (221) and a second light emitting element (22) contained in the second matte cover (221), and the second matte cover (221) is installed between a side of the mirror (21) and the two rail structures (3).

8. The smart mirror device according to claim 6, wherein each rail structure (3) comprises a chute (31) formed on the display device (1) and a slider (32) extending from the mirror cover (2), and each slider (32) slides in each respective chute (31).

9. The smart mirror device according to claim 1, wherein the display device (1) has a front (13) and a back (14), and the screen (11) is installed at the front (13), and a hook (5) or a support base (6) is installed at the back (14).

10. The smart mirror device according to claim 1, further comprising a rotating support (4), a rotary head (41) of the rotating support (4), and a support (42) pivotally coupled to the rotary head (41), and the display device (1) having a front (13) and a back (14), and the screen (11) being installed at the front (13), and the back (14) having a snap slot (15), and the rotary head (41) being rotatably embedded into the snap slot (15) with 360 degrees.

11. The smart mirror device according to claim 2, wherein the display device (1) has two lighting assemblies (16) installed two opposite outer sides of the screen (11) respectively, and the sensor (112) lights up the two lighting assemblies (16) when receiving a user's operation.

12. The smart mirror device according to claim 11, wherein both of the display device (1) and the mirror cover (2) are disposed on two rail structures (3') on both left and right sides of the screen (11) respectively, and the mirror cover (2) slides along the two rail structures (3').

13. The smart mirror device according to claim 12, wherein each lighting assembly (16) comprises a matte cover (161) and a light emitting element contained in the matte cover (161), and the two rail structures (3') are installed between the outer side of the screen (11) and the inner side of the two matte covers (161), and each rail structure (3') comprises a chute (31') formed on the display device (1) and a slider (32') extending from the mirror cover (2), and each slider (32') slides in each respective chute (31').
